# EUROPEAN PATENT APPLICATION

(11) **EP 1 978 514 A1**
(43) Date of publication of application: **08.10.2008**
(21) Application number: 07105513.1
(22) Date of filing: 03.04.2007
(51) Int. Cl.: G11B 7/09

(54) **Pickup for accessing moving storage media and drive having the pickup**

(71) Applicant: Deutsche Thomson OHG, 30625 Hannover (DE)
(72) Inventor: Bammert, Michael, 78739 Hardt (DE); Suzuki, Tsuneo, 78087 Mönchweiler (DE); Dupper, Rolf, 78050 Villingen-Schwenningen (DE)
(74) Representative: Thies, Stephan

(57) **Abstract**

A pickup (P) for accessing moving storage media (D) carrying substantially parallel information tracks (T) has a carrier (C), a movable actuator (A) with a lens (3), and suspension wires (4) joining the carrier (C) and the actuator (A). The actuator (A) is movable in at least a tracking direction (X) and a focus direction (y. The suspension wires (4) are soldered to the actuator (A) by soldering points (5). According to the invention, the soldering points (5) are made by induction soldering.

## Description

### BACKGROUND OF THE INVENTION

### FIELD OF THE INVENTION

The present invention is related to a pickup for accessing moving storage media according to the preamble of claim 1. Pickups are used as part of a recording and/or reproducing apparatus, e. g. of Optical Disk players, Optical Disk recorders or of similar apparatuses.

### DESCRIPTION OF THE PRIOR ART

A pickup for accessing moving storage media records and/or reproduces information with respect to the moving storage media carrying substantially parallel information tracks, namely a turning disk, while moving in the radial direction of the disk. In the pickup, typically one or more light beams are generated and focused onto a target or scanning spot on a layer within the disk. Readout light beams coming from the disk are projected onto a photo detector, where they are converted into electrical signals for further evaluation.

A well-known pickup has a carrier, a movable actuator with a lens, and suspension wires joining the carrier and the actuator and being, in particular, soldered to the actuator by soldering points.

The suspension wires serve two purposes: mechanically they movably support the actuator, and electrically they allow to apply currents to coils on the actuator. The coils on the actuator and a magnet configuration on the carrier, all together referred to as a magnetic driving portion, initiate the movements of the actuator. The actuator is movable relative to the carrier in at least a focus direction and a tracking direction.

The soldering points are made by soldering with a soldering gun or soldering iron. The pickup has to be constructed in a way that assures good accessibility to the soldering points for the soldering gun. A good accessibility for the soldering gun can cause stability problems and/or problems of mechanical resonance.

### SUMMARY OF THE INVENTION

It is therefore desirable to improve a pickup, according to the preamble of claim 1, with reference to the connection of the suspension wires to the actuator.

According to the invention this is achieved by the features of claim 1. Possible advantageous developments of the invention are specified in the dependent claims.

A pickup for accessing moving storage media carrying substantially parallel information tracks, has a carrier, a movable actuator with a lens and suspension means joining the carrier and the actuator. The actuator is movable in at least a focus direction and a tracking direction. The suspension wires are soldered to the actuator by soldering points. According to the invention the soldering points are made by induction soldering.

Advantageously, soldering points made by induction soldering can be covered by the structure of the actuator A. Only very small openings are needed for an access for the soldering paste. As a result, the structure of the actuator can be more stable, and resonance problems of the actuator are decreased. In addition, induction soldering enables a transfer of a large amount of energy and needs little service and maintenance.

Preferably, the pickup comprises suspension wires, which extend substantially in an information direction orthogonal to the tracking direction and the focus direction. The actuator comprises a printed circuit board, which carries coils and extends in a plane spanned by the tracking direction and the focus direction. The soldering points for the suspension wires are arranged at opposite ends of the printed circuit board, in the tracking direction. The soldering points are arranged at the borders of the printed circuit board PCB, close to the area where the moving force generated by the interaction of the coils on the PCB with the magnets is mechanically transmitted from the PCB to the actuator. The soldering points made by induction soldering enable a stable construction of the actuator part surrounding the borders of the printed circuit board, and thus to reduce resonance problems.

Preferably, the pickup comprises an actuator with a frame-shaped body carrying the lens and the printed circuit board, the latter extending through the inside of the body. The body is provided with reinforcement elements outside of the opposite ends of the printed circuit board in the tracking direction. Each reinforcement element comprises at least one small opening. Preferably, the reinforcement elements comprise a small opening, e.g. a bore hole, for each soldering point. The openings enable to introduce soldering paste by a dispenser for the induction soldering of the soldering points on the printed circuit board, which is at least laterally covered by the reinforcement elements. The reinforcement elements make the actuator more stable, while decreasing resonance problems of the actuator.

Preferably a moving storage media drive is provided with a pickup according to the invention.

The carrier being an ensemble of rigidly connected elements, does not preclude that typically the pickup as a whole, including the carrier, suspension wires and an actuator, is movable and is being moved, so that all storage locations on the medium can be accessed, in a direction orthogonal to information tracks on the storage medium. In this, accessing shall encompass reading access for reading information from the storage medium, or writing access for writing or recording information onto the storage medium, or combinations of reading and writing access.

One possible form of moving storage media is disks carrying concentric circular or spiral information tracks, with the access being of a reflective type where an access light beam is generated and focused onto the information track and a reflected light beam, coming back from and being modulated by the information track is being focused onto a photo detector arrangement and being evaluated. However, it is within the scope of this invention for it to be used on other forms of optical recording medium having information tracks in layers, such as those in card or tape form; and regardless whether the access principle is of a reflective or transductive type.

### BRIEF DESCRIPTION OF THE DRAWINGS

The invention will be explained in more detail using two embodiments, illustrated in figures 1 to 5.

In the figures:
- Figure 1: shows a simplified perspective view of a pickup known by the applicant;
- Figure 2: shows another simplified perspective view of the pickup of figure 1;
- Figure 3: shows a simplified perspective view of a pickup of the invention;
- Figure 4: shows an enlarged detail of figure 3; and
- Figure 5: shows another simplified perspective view of the pickup of figure 3.

### DETAILED DESCRIPTION OF THE INVENTION

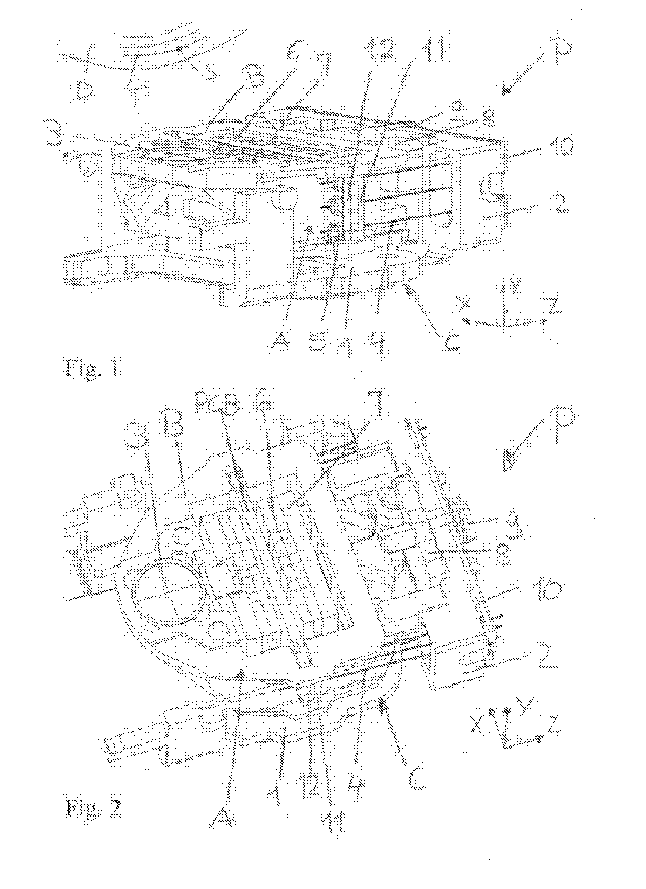

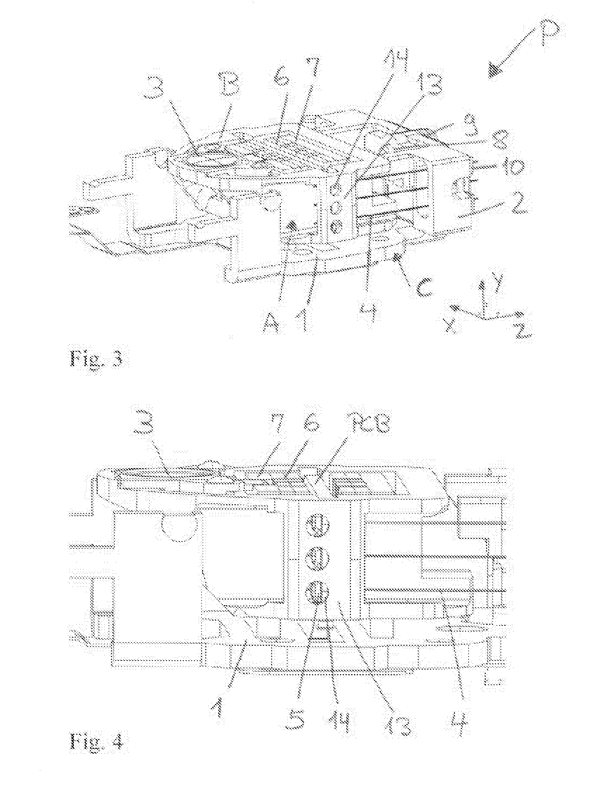

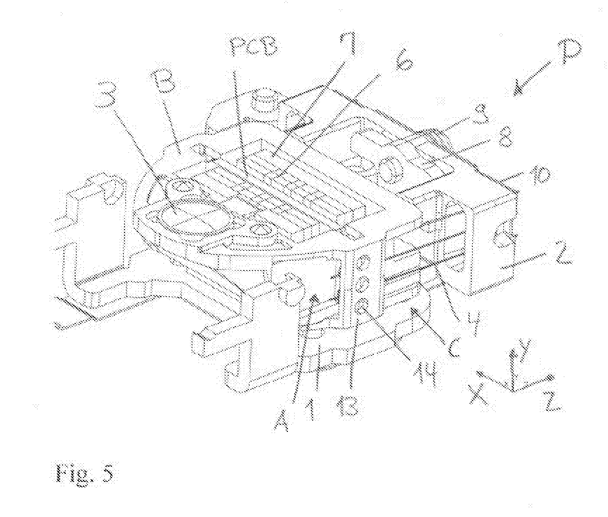

Figures 1 and 2 show a pickup P with conventional soldering points, whereas Figures 3 to 5 show the pickup P of Figures 1 and 2 with modifications according to the invention, in particular with soldering points made by induction soldering. The pickup of Figures 1 and 2 illustrates the stability and resonance problems of an actuator design providing for accessibility of the conventional soldering points. These problems are solved using the modified pickup P of Figures 3 to 5, according to the invention.

The pickup P, shown in **Figures 1 and 2**, for accessing moving storage media, namely a disk D, has a carrier C with a base 1 and a holder 2, an actuator A with a lens 3, and suspension wires 4 joining the carrier C and the actuator A. The pickup P has six suspension wires 4 extending from the rear of the holder 2 to the actuator A.

By means of the suspension with the suspension wires 4, the actuator A with the lens 3 is able to perform focus motion in a focus direction Y orthogonal to the disk D carrying substantially circular information tracks T, shown in Figure 1 at very enlarged, disproportionate distance. Additionally, the actuator A is able to perform tracking motion in a tracking direction X parallel to the surface of the disk D and orthogonal to the information tracks T. Additionally, the actuator A is able to perform so-called radial tilt motion by rotating around an information direction Z which is parallel to the direction of the tracks T, namely to the tangent to the information tracks T at a scanning spot S, and orthogonal to the tracking direction X and the focus direction Y.

The suspension wires 4 extend in the information direction Z and are soldered to the actuator A by soldering points 5. In particular, the actuator A comprises a body B and a printed circuit board PCB which extends in a plane spanned by the tracking direction X and the focus direction Y. The six suspension wires 4 are arranged substantially in parallel. They are oriented in the information direction Z. They are arranged symmetrically with respect to the body B and the printed circuit board PCB. Three suspension wires 4 end at each of two opposite ends of the printed circuit board PCB, in the tracking direction X. The three suspension wires 4 are arranged on top of each other in the focus direction Y, at each end of the printed circuit board PCB and are soldered with one end to the printed circuit board PCB by soldering points 5. In particular, the suspension wires 4 extend with their ends through openings from the rear to the front of the printed circuit PCB board and are soldered onto its front side by the soldering points 5.

The body B of the actuator A is constituted as a frame-shaped body B carrying the lens 3, where the printed circuit board PCB is connected to the body B and extends through an inner opening of the body B. The printed circuit board PCB carries tracking, focus and tilt coils, which are occluded in the Figures.

The pickup P has a magnet configuration, which is connected to the carrier C, with two multipolar magnets 6 and with two yokes 7. The yokes 7, each carrying one of the multipolar magnets 6, extend vertically from the base 1, namely in the focus direction Y. The yokes 7 with the multipolar magnets 6 are arranged in the inner opening of the body B in a way that each of the multipolar magnets 6 faces the printed circuit board PCB at one of its opposite sides in the information direction Z.

The base 1 extends in a plane orthogonal to the focus direction Y and parallel to the disk D, i.e. in the plane spanned by the tracking direction X and the information direction Z. The holder 2 is connected to a strap 8 of the base 1 by as screw 9. The holder 2 comprises a second printed circuit board 10 with soldering points for the other end of the suspension wires 4. The second printed circuit board 10 is located behind the actuator A, in other words, at that side of the holder 2 which is opposite to the body B. The holder 2 is constituted by a damping block with a damping material inside, which damps the suspension wires 4 extending through the holder 2.

With reference to **Figures 1 and 2**, the soldering points 5 are made by conventional soldering. The body B of the pickup P is provided with reinforcement ribs 11, which extend in focus direction Y, outside of the opposite ends at the borders of the printed circuit board PCB in the tracking direction X. The ribs 11 constitute the connections to the printed circuit board PCB and comprise openings 12, both the ribs 11 and the openings 12 extending in focus direction Y. The openings 12 enable the soldering of the soldering points 5 on the printed circuit board PCB, by a soldering gun with a fine tip.

The required size of the openings 12 makes the actuator A instable and causes resonances problems. The stability problems arise in a section of the actuator A, namely at the borders of the printed circuit board PCB, where the moving force transits from the PCB to the actuator A.

The pickup P shown in Figures 3 to 5 corresponds to the pickup of Figures 1 and 2, except for the following features:

According to the invention, with reference to **Figures 3 to 5**, the soldering points 5 are made by induction soldering. The body B of the pickup P is provided with reinforcement elements 13, which extend in focus direction Y and in information direction Z, outside of the opposite ends of the printed circuit board PCB, in the tracking direction X. The reinforcement elements 13 constitute the connections to the printed circuit board PCB and are embodied as reinforcement plates with openings 14. In particular, each reinforcement element 13 comprises three small openings 14, which are arranged on top of each other in the focus direction Y. The openings 14 in the form of small bore holes enable to introduce soldering paste by a dispenser for the induction soldering of the soldering points 5 on the printed circuit board PCB, where the soldering points 5 are at least laterally covered by the reinforcement plates.

The reinforcement elements 13, which are constructed as reinforcement plates with only small openings 14, make the actuator A more stable, while decreasing resonance problems of the actuator A.

As an alternative, the printed circuit board PCB can carry coils of a fine pattern structure. As an alternative, the actuator A can be provided with a flat board with attached coils, instead of the printed circuit board PCB.

A pickup P according to this invention can be used in the so-called slide or sled design of optical media drives, where it is shiftably fitted to a frame structure of the drive, with appropriate linear driving means for realising the shift, such as linear motors or a motor driven threaded rod. Alternatively, the pickup P according to this invention is also usable in the so-called swivel arm design, where it is pivotably mounted on the end of an arm having a pivoting axis parallel to the focus direction. In that way, the pickup P is movable across the tracks T on the surface of the disk D along an arc which has its main extension in the tracking direction X.

## Claims

1. A pickup (P) for accessing moving storage media (D) carrying substantially parallel information tracks (T),
the pickup (P) having a carrier (C), an actuator (A) with a lens (3), and suspension wires (4) joining the carrier (C) and the actuator (A), the actuator (A) being movable in a tracking direction (X) and in a focus direction (Y), and
the suspension wires (4) being soldered to the actuator (A) by soldering points (5),
the pickup (P) **characterized in that** the soldering points (5) are made by induction soldering.

2. A pickup (P) according to claim 1,
where the suspension wires (4) extend substantially in an information direction (Z) orthogonal to the tracking direction (X) and the focus direction (Y),
where the actuator (A) comprises a printed circuit board (PCB) carrying coils and extending in a plane spanned by the tracking direction (X) and the focus direction (Y), and
where the soldering points (5) for the suspension wires (4) are arranged at the printed circuit board (PCB) at its opposite ends in the tracking direction (X).

3. A pickup (P) according to claim 2,
where the actuator (A) comprises a frame-shaped body (B) carrying the lens (3) and the printed circuit board (PCB) extending through an inner opening of the body (B), where the body (B) is provided with reinforcement elements (13) outside of the opposite ends of the printed circuit board (PCB) in the tracking direction (X), and where the reinforcement elements (13) surround the soldering points (5).

4. A pickup according to Claim 3, where the reinforcement elements (13) comprise small openings (14).

5. A pickup (P) according to claim 4,
where the reinforcement elements (13) comprise one small opening (14) for each soldering point (5).

6. A moving storage media drive **characterised in that** it has a pickup (P) according to one of the claims 1 to 5.
